(19) Europäisches Patentamt

European Patent Office

Office européen des brevets

(11) EP 1 098 371 B1

(12) EUROPEAN PATENT SPECIFICATION

(45) Date of publication and mention
of the grant of the patent:
**24.05.2006 Bulletin 2006/21**

(51) Int Cl.:
*H01L 29/06* (2006.01)        *H01L 29/32* (2006.01)

(21) Application number: **00309457.0**

(22) Date of filing: **27.10.2000**

(54) **A semiconductor device with good reverse recovery withstand and the method of manufacturing the same**

Halbleiteranordnung mit guter Sperrverzögerungsfestigkeit und Verfahren zur Herstellung

Dispositif semi-conducteur ayant une bonne tenue au recouvrement inverse et procédé pour sa fabrication

(84) Designated Contracting States:
**DE FR GB**

(30) Priority: **05.11.1999 JP 31542799**

(43) Date of publication of application:
**09.05.2001 Bulletin 2001/19**

(73) Proprietor: **FUJI ELECTRIC CO. LTD.**
**Kawasaki 210 (JP)**

(72) Inventors:
 • **Yoshikawa, Ko,**
   **Fuji Electric Co. Ltd.**
   **Kawasaki 210 (JP)**
 • **Fujii, Takeshi,**
   **Fuji Electric Co. Ltd.**
   **Kawasaki 210 (JP)**
 • **Nemoto, Michio,**
   **Fuji Electric Co Ltd.**
   **Kawasaki 210 (JP)**

(74) Representative: **Bridge-Butler, Alan James et al**
**G.F. Redfern & Co.**
**Lynn House**
**Ivy Arch Road**
**Worthing,**
**West Sussex BN14 8BX (GB)**

(56) References cited:
  **WO-A-99/09600        DE-A- 4 135 258**
  **US-A- 5 747 371**

 • **PATENT ABSTRACTS OF JAPAN vol. 016, no. 170 (E-1194), 23 April 1992 (1992-04-23) -& JP 04 017372 A (HITACHI LTD;OTHERS: 01), 22 January 1992 (1992-01-22)**
 • **PATENT ABSTRACTS OF JAPAN vol. 1996, no. 03, 29 March 1996 (1996-03-29) -& JP 07 297414 A (TOSHIBA CORP), 10 November 1995 (1995-11-10)**
 • **KUSHIDA T ET AL: "A He-irradiated IGBT with a shallow p-base and shallow FLRs" POWER SEMICONDUCTOR DEVICES AND IC'S, 1997. ISPSD '97., 1997 IEEE INTERNATIONAL SYMPOSIUM ON WEIMAR, GERMANY 26-29 MAY 1997, NEW YORK, NY, USA,IEEE, US, 26 May 1997 (1997-05-26), pages 277-280, XP010232452 ISBN: 0-7803-3993-2**

## Description

The present invention relates to a semiconductor device that facilitates preventing reverse recovery breakdown from occurring. Specifically, the present invention relates a semiconductor structure that facilitates relaxing current localization to the vicinity of the electrode of a diode and such a semiconductor device which exhibit rectifying function. The invention relates also to the method of manufacturing the semiconductor device.

In association with the recent achievements for the power semiconductor devices such as the loss reduction, the switching speed increase, the reduction of the inductance in the peripheral circuits and the elimination of the snubber circuit, it is required to improve the reverse recovery characteristics (such as the reverse-recovery withstanding capability, the reverse recovery loss and the soft witching function) of the diode (freewheel diode: FWD) used in combination with the power switching devices.

Especially, the change of reverse recovery current with time dI/dt, closely related with the reverse-recovery withstanding capability, has been increased year by year. Due to this, it is indispensable to improve the withstanding capability against dI/dt (hereinafter referred to as the "dI/dt withstanding capability").

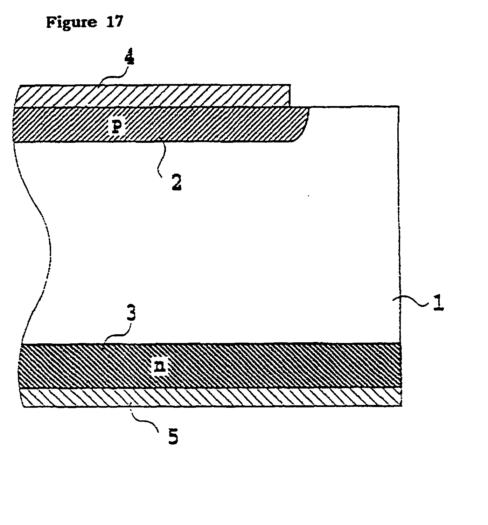

Figure 17 is a cross sectional view of a conventional fundamental p-i-n diode.

Referring now to Figure 17, a p-type anode layer 2 is on a first major surface of an n-type semiconductor substrate 1, and an n-type cathode layer 3 is on a second major surface of n-type semiconductor substrate 1.

When a forward bias voltage is applied to the diode of Figure 17 (a positive voltage to p-type anode layer 2 and a negative voltage to n-type cathode layer 3) and when the forward voltage across the pn-junction between p-type anode layer 2 and n-type semiconductor substrate 1 exceeds about 0.6 V (in the case, wherein the semiconductor is silicon), holes are injected from p-type anode layer 2 to n-type semiconductor substrate 1 and electrons are injected from n-type cathode layer 3 to n-type semiconductor substrate 1 so that the condition of electrical neutrality may be established. (Hereinafter, the electrons and the holes accumulated excessively in semiconductor substrate 1 will be referred to as the "accumulated carries".) As a result, a conductivity modulation is caused in semiconductor substrate 1, and the resistance of semiconductor substrate 1 becomes extremely small such that semiconductor substrate 1 is conductive.

Although the anode electrode is formed on the portion of the first major surface, below that any structure for bearing the breakdown voltage (hereinafter referred to as a "breakdown withstanding structure) is not formed, the cathode electrode is formed on the entire second major surface. Due to this, accumulated carriers exist also below the breakdown withstanding structure.

There exists a reverse recovery step during the transition, so that the forward bias state shifts to the reverse bias state. The reverse recovery is a phenomenon in that the carriers, excessively accumulated by the forward bias voltage application, keep flowing in the reverse direction (a short circuit state) in a short period of time when a reverse bias voltage is applied until the excessively accumulated carriers vanish.

The reverse recovery breakdown occurs usually in the boundary region between the active region and the breakdown withstanding structure region of the diode. The reverse recovery breakdown is a thermal breakdown caused by electric field localization and current localization to the boundary region.

The electric field localization is caused by the cylindrical or spherical pn-junction formed in the edge area of the anode region. The current localization is caused by the flow of the accumulated carriers, accumulated below the breakdown withstanding structure, to the anode electrode during the reverse recovery.

The countermeasures according to the prior art include prevention of electric field localization by deepening the pn-junction in the edge area of the anode region and separation of the region, therein electric field localization occurs, and the region therein current localization occurs, from each other by positioning the portion, where the anode electrode and the anode region contact with each other, away from the edge area of the anode region.

However, these countermeasures are not fully effective to improve the reverse-recovery withstanding capability, since the countermeasures do not prevent current localization from occurring.

DE 4135258 in the name of SEMIKRON ELEKTRONIK GMBH discloses a semiconductor device including a semiconductor substrate, a heavily doped region and an electrode, in which the semiconductor substrate is a lightly doped layer of a first conductivity type, the heavily doped region is of a second conductivity type, and the electrode contacts the heavily doped region. The semiconductor substrate has a first carrier lifetime region and a second carrier lifetime region, and the carrier lifetime in the first region is shorter than in the second region.

However, the first carrier lifetime region and the electrode are formed over the whole semiconductor substrate surface, and the heavily doped region does not extend beyond the electrode. This arrangement causes forward voltage of a diode to be high.

In view of the foregoing, it is an object of the invention to provide a semiconductor device including a simple means that facilitates preventing current localization from occurring in the vicinity of the electrode thereof and improving the reverse-recovery withstanding capability thereof, and without causing forward voltage to be high.

Therefore, according to the invention a semiconductor device comprises a semiconductor substrate, a heavily doped region and an electrode, in which the semiconductor substrate is a lightly doped layer of a first conductivity type, in which the heavily doped region is of a second conductivity type and is formed selectively in the lightly doped layer, in which the electrode is formed on a surface of the semiconductor substrate, in which the electrode is in contact with said heavily doped region, in which the semiconductor substrate comprises: a first carrier lifetime region; and a second carried lifetime region; in which the carrier lifetime in the first carrier lifetime region is shorter than the carrier lifetime in the second carrier lifetime region, characterised in that the heavily doped region has a projection region which extends beyond the electrical contact area between the electrode and the semiconductor substrate; in that the first carrier lifetime region extends vertically into the semiconductor substrate, and partially overlaps with an edge area of the electrode facing vertically into the semiconductor substrate, and in that the first carrier lifetime region includes a boundary area in which the heavily doped region spreads into the lightly doped layer.

Advantageously, the first carrier lifetime region extends over only an outermost edge area of the electrode facing the semiconductor substrate, which outmost edge area is near to an edge area of the semiconductor device.

Advantageously, the first carrier lifetime region extends perpendicular to a surface of the semiconductor substrate, on which the electrode is formed.

Advantageously, the depth Da of the first carrier lifetime region from the surface of the semiconductor substrate on which the heavily doped region is formed, the diffusion length Ls of the carriers in the first carrier lifetime region and the depth Xj of the pn-junction between the heavily doped region of the second conductivity type and the lightly doped layer are related to each other by the following relational expression.

$$Da > Ls + Xj$$

Advantageously, the width La of the portion of the first carrier lifetime region, which overlaps with the electrode, and the diffusion length Ls of the carriers in the first carrier lifetime region are related to each other by the following relational expression.

$$La > Ls$$

Advantageously, the width Lb of a portion of the first carrier lifetime region, which does not overlap with the electrode, and the diffusion length Lh of the carriers in the second carrier lifetime region are related to each other by the following relational expression.

$$Lb > Lh$$

According to a second aspect of the present invention a method of manufacturing a semiconductor device comprising a semiconductor substrate, a heavily doped region and an electrode, in which the semiconductor substrate is a lightly doped layer of a first conductivity type, in which the heavily doped region is of a second conductivity type and is formed selectively in the lightly doped layer, in which the electrode is formed on a surface of the semiconductor substrate, in which the electrode is in contact with said heavily doped region, in which the semiconductor substrate comprises a first carrier lifetime region and a second carried lifetime region, in which the carrier lifetime in the first carrier lifetime region is shorter than the carrier lifetime in the second carrier lifetime region, characterised in that the heavily doped region has a projection region which extends beyond the electrical contact area between the electrode and the semiconductor substrate; in that the first carrier lifetime region extends vertically into the semiconductor substrate, and partially overlaps with an edge area of the electrode facing vertically into the semiconductor substrate, and in that the first carrier lifetime region includes a boundary area in which the heavily doped region spreads into the lightly doped layer, in which the method comprises irradiating a particle beam to form the first carrier lifetime region.

Advantageously, the particle beam is irradiated from a surface of the semiconductor substrate on which the electrode is formed.

Advantageously, the particle beam includes $He^{2+}$ ions or protons.

Advantageously, $He^{2+}$ ions are irradiated at the amount of dose of $1 \times 10^{10}$ cm$^{-2}$ or more.

Advantageously, the carrier lifetime in the first carrier lifetime region is 1/3 or less of the carrier lifetime in the second carrier lifetime region.

Advantageously, the semiconductor device is a diode, the heavily doped region is an anode layer, and the electrode is an anode electrode.

Embodiments of the invention will now be described with reference to the accompanying drawings, in which:

Figure 1 is a cross sectional view of a p-i-n diode according to a first embodiment of the invention;
Figure 2 is a graph describing the relation between the amount of dose of $He^{2+}$ ion and the dI/dt withstanding capability of a p-i-n diode exhibiting a breakdown voltage of the 4500 V class;
Figure 3 is a graph describing the relation between the amount of dose of $He^{2+}$ ion and the forward voltage of the p-i-n diode exhibiting a breakdown voltage of the 4500 V class;
Figure 4 is a graph describing the relation between the width Lb of the first carrier lifetime region, that the anode electrode is not overlapping, and the dI/dt withstanding capability of the p-i-n diode exhibiting a breakdown voltage of the 4500 V class at the width

La of 50 $\mu$m of the first carrier lifetime region, that the anode electrode is overlapping, the depth Da of 30 $\mu$m of the first carrier lifetime region from the surface of the semiconductor substrate on the side, on that the p-type anode layer is formed, and the He$^{2+}$ ion amount of dose of 1.0 x 10$^{12}$ cm$^{-2}$;

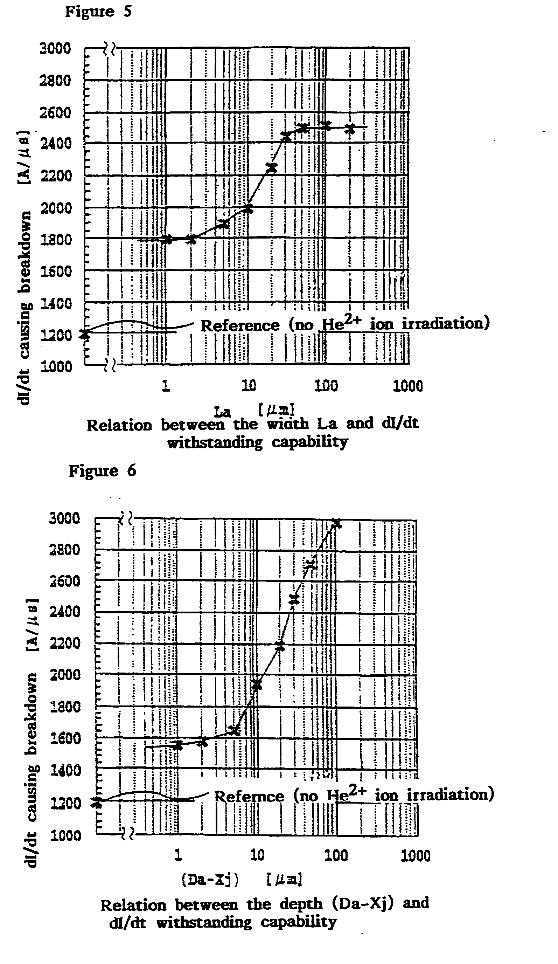

Figure 5 is a graph describing the relation between La and the dI/dt withstanding capability of the p-i-n diode exhibiting a breakdown voltage of the 4500 V class at Lb of 200 $\mu$m, Da of 30 $\mu$m and the He$^{2+}$ ion amount of dose of 1.0 x 10$^{12}$ cm$^{-2}$;

Figure 6 is a graph describing the relation between Da and the dI/dt withstanding capability of the p-i-n diode exhibiting a breakdown voltage of the 4500 V class at La of 100 $\mu$m, Lb of 100 $\mu$m and the He$^{2+}$ ion amount of dose of 1.0 x 10$^{12}$ cm$^{-2}$;

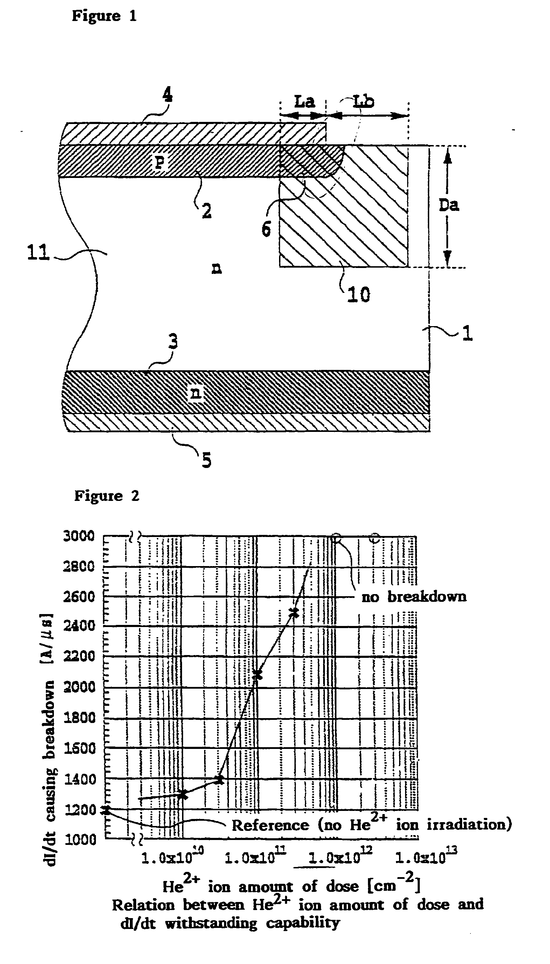

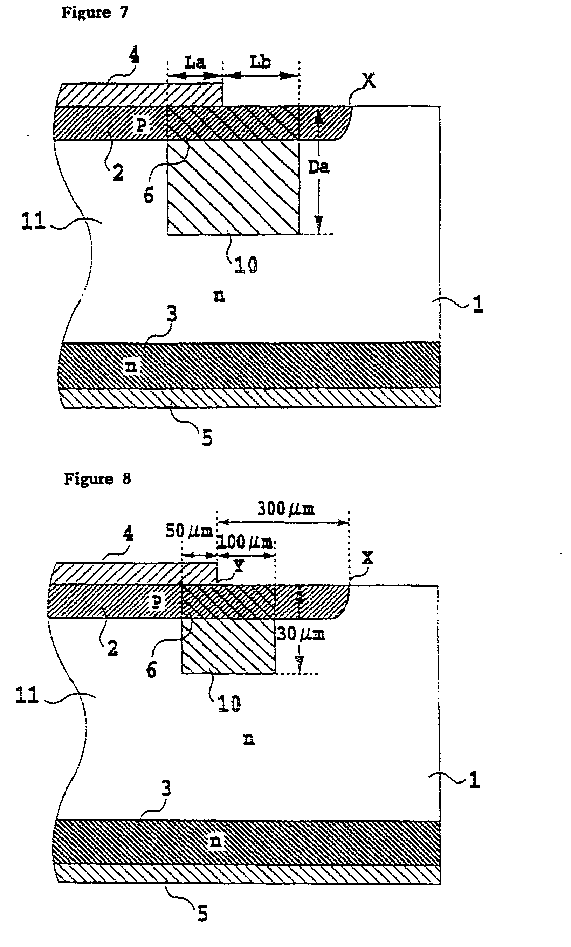

Figure 7 is a cross sectional view of a p-i-n diode according to a second embodiment of the invention that includes a first carrier lifetime region 10, in that the carrier lifetime is short, in the other location of the semiconductor substrate different from the location of the first carrier lifetime region shown in Figure 1;

Figure 8 is the cross sectional view describing the practical structural parameters of the p-i-n diode according to the second embodiment;

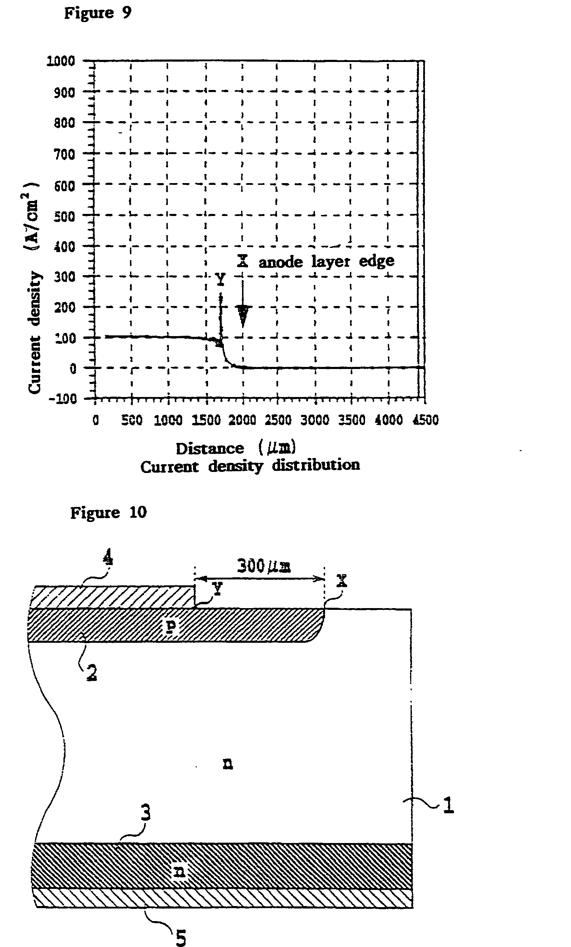

Figure 9 is a graph showing the simulated current density distribution in the vicinity of the pn-junction of the p-i-n diode shown in Fig, 8, to that He$^{2+}$ ion irradiation is applied;

Figure 10 is a cross sectional view of a comparative diode structure;

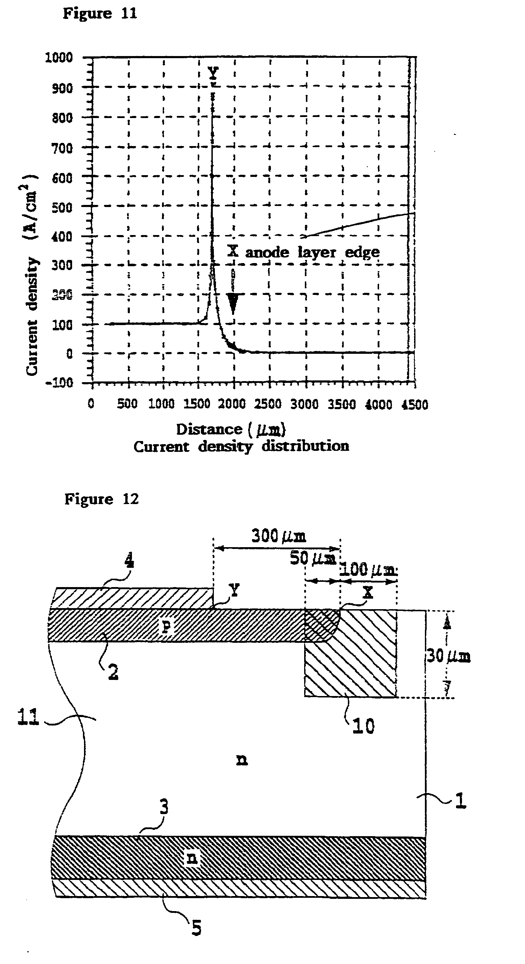

Figure 11 is a graph describing the current density distribution in the comparative diode structure of Figure 10;

Figure 12 is a cross sectional view of another comparative diode structure, in that first carrier lifetime region 10, in that the carrier lifetime is short, is formed not below the anode electrode but in the edge area X of the p-type anode region;

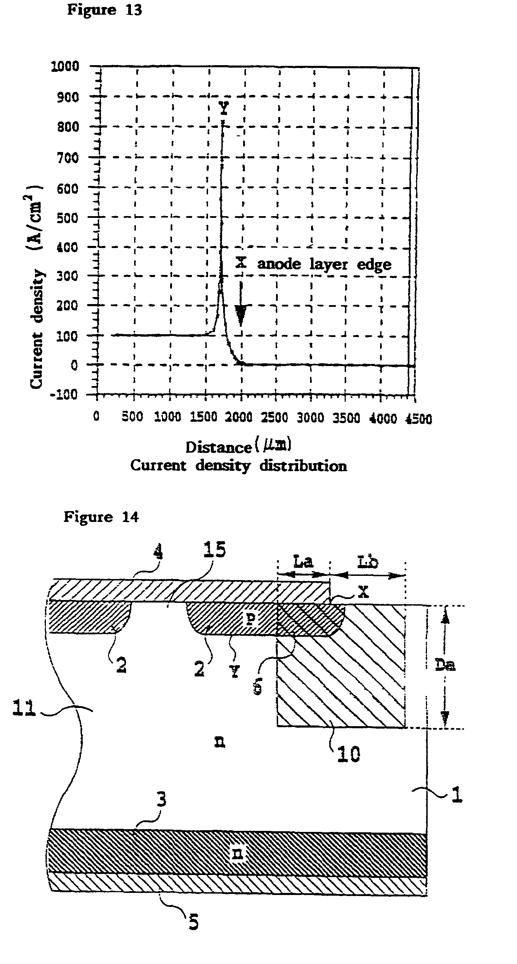

Figure 13 is a graph describing the current density distribution in the comparative diode structure of Figure 12;

Figure 14 is a cross sectional view of a p-i-n diode according to a third embodiment of the invention;

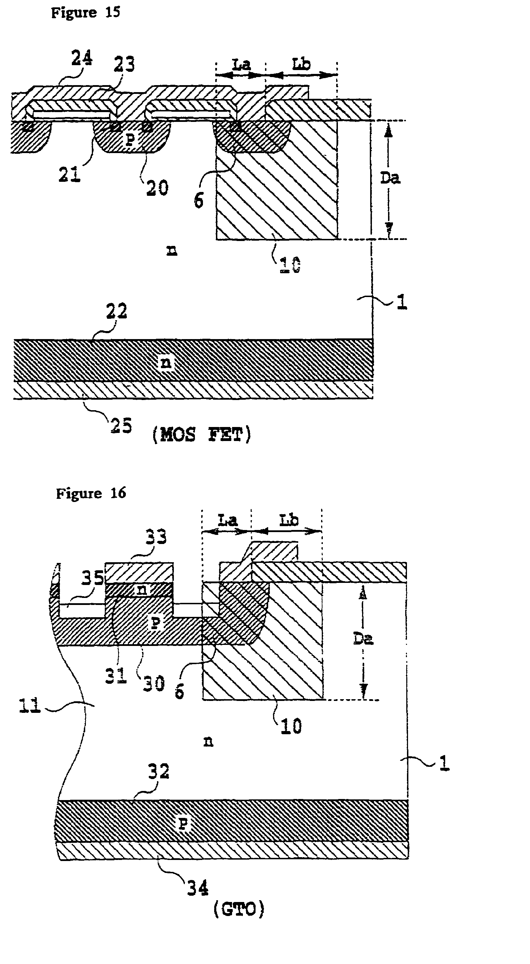

Figure 15 is a cross sectional view of a MOSFET according to a fourth embodiment of the invention;

Figure 16 is a cross sectional view of a gate turnoff thyristor (GTO) according to a fifth embodiment of the invention; and

Figure 17 is a cross sectional view of a conventional fundamental p-i-n diode.

Now the first embodiment of the invention will be explained with reference to Figures 1 through 6.

First, the structure of a diode according to the first embodiment of the invention is described with reference to Figure 1.

Referring now to Figure 1, an n-type semiconductor substrate 1 is formed as a lightly doped semiconductor layer. A p-type anode layer 2 is formed as a heavily doped conductive region selectively on a first major surface of n-type semiconductor substrate 1. An n-type cathode layer 3 is formed as another heavily doped conductive region on a second major surface of n-type semiconductor substrate 1.

A metal anode electrode 4 is formed on p-type anode layer 2. The edge area of anode electrode 4 is spaced apart for 10 $\mu$m inward from the edge area of p-type anode layer 2. A cathode electrode 5 is formed on an entire surface of n-type cathode layer 3.

A first carrier lifetime region 10 and a second carrier lifetime region 11 are formed in n-type semiconductor substrate 1 so that the diode according to the first embodiment may exhibit two carrier lifetimes. First carrier lifetime region 10 extends vertically into the semiconductor substrate 1, and partially overlaps with an edge area of the electrode 4 facing vertically into the semiconductor substrate 1. First carrier lifetime region 10 also includes a boundary area 6 in which the p-type anode layer 2 spreads into the lightly doped layer of n-type semiconductor substrate 1.

The other region of n-type semiconductor substrate 1, that is not assigned to first carrier lifetime region 10, is second carrier lifetime region 11, in that the carrier lifetime is long.

Now the dimensions of first carrier lifetime region 10, in that the carrier lifetime is short, are described. The width of region 10, which overlaps with anode electrode 4, is represented by La, and the width of region 10, which does not overlap with anode electrode 4, is represented by Lb, and the depth of region 10 from the surface of semiconductor substrate 1 on the side, on that p-type anode layer 2 is formed, is represented by Da. In the diode according to the first embodiment, La = 50 $\mu$m, Lb = 2400 $\mu$m, and Da = 30 $\mu$m. The dimensions of first carrier lifetime region 10 is not limited to those described above.

In the diode according to the first embodiment, the resistivity of n-type semiconductor substrate 1 is 300 $\Omega$ cm. The thickness of n-type semiconductor substrate 1 is 550 $\mu$m. The surface impurity concentration of p-type anode layer 2 is 3.0 x 10$^{16}$cm$^{-3}$. The diffusion depth of p-type anode layer 2 is 5.0 $\mu$m. The surface impurity concentration of n-type cathode layer 3 is 1.0 x 10$^{20}$cm$^{-3}$. The diffusion depth of n-type cathode layer 3 is 80.0 $\mu$m.

The method of manufacturing the semiconductor device according to the first embodiment of the invention will be described.

In manufacturing the semiconductor substrate of the diode according to the first embodiment, the manufacturing steps are controlled so that the semiconductor substrate may exhibit two carrier lifetimes. Region 10, in that the carrier lifetime is short, is formed such that region 10 extends across the edge area of anode electrode 4 and includes boundary area 6 below the edge area of anode electrode 4.

Region 10, in that the carrier lifetime is short, is formed easily by the method of introducing crystal defects that employs particle beam irradiation such as He ion irradiation and proton ion irradiation.

A mask has a window corresponding to the region, in that the carrier lifetime is to be short, is fabricated using a material (such as aluminium metal and a thick resist film), that is capable of blocking He ion and proton. The mask is positioned partly on the surface of p-type anode layer 2 and partly on the exposed surface portion of n-type semiconductor substrate 1. He ions or protons are irradiated vertically onto the mask.

Since He ion and proton exhibit respective ranges corresponding to the acceleration voltage, only the not masked portion of n-type semiconductor substrate 1 beneath the window of the mask is irradiated as far as the mask is thick enough. Thus, crystal defects are introduced in the not masked portion of n-type semiconductor substrate 1. Therefore, the region of n-type semiconductor substrate 1, therein crystal defects are introduced, is region 10, in that the carrier lifetime is short.

When n-type semiconductor substrate 1 is thick, crystal defects may be introduced by irradiating multiple times with the irradiation depth changed every time. Crystal defects may be introduced also by setting a longer irradiation depth longer than the thickness of the semiconductor substrate and by transmitting He ions or protons through n-type semiconductor substrate 1.

The carrier lifetime in the region, in that the carrier lifetime is long, is adjusted by adjusting the average carrier lifetime in the semiconductor substrate. The average carrier lifetime in the semiconductor substrate is adjusted by irradiating an electron beam or diffusing heavy metal after the above described ion irradiation.

More in detail, first carrier lifetime region 10, in that the carrier lifetime is short, is formed by irradiating $He^{2+}$ ions using a resist film of 50 $\mu$m in thickness as a mask (and by subsequent heat treatment). Second carrier lifetime region 11, in that the carrier lifetime is long, is formed by irradiating electron beams (and by subsequent heat treatment). The carrier lifetime is varied by changing the amount of dose of $He^{2+}$ ion from 0 (no irradiation) to $1.0 \times 10^{12}$ cm$^{-2}$.

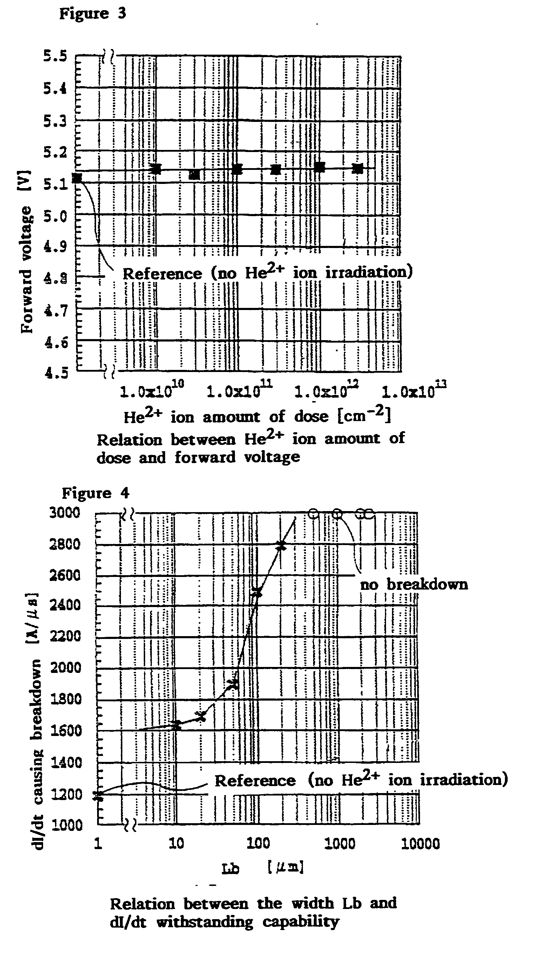

Now the investigations conducted on the p-i-n diode according to the first embodiment will be described with reference to Figures 2 and 3. The results of the investigations conducted on the p-i-n diode exhibiting a breakdown voltage of the 4500 V class are described in Figures 2 and 3.

Figure 2 is a graph describing the relation between the amount of dose of $He^{2+}$ ion and the withstanding capability against change of the reverse recovery current with time dI/dt (the dI/dt withstanding capability) of the p-i-n diode exhibiting a breakdown voltage of the 4500 V class.

The carrier lifetime in second carrier lifetime region 11, in that the carrier lifetime is long, is 5 $\mu$s and the

carrier diffusion length is 100 $\mu$m. The other conditions for the reverse recovery test include the forward current of 170 A/cm$^2$, the DC voltage of 2600 V, and the junction temperature of 125°C.

The dI/dt withstanding capability is improved by forming region 10, in that the carrier lifetime is short, such that region 10 extends across the edge area of anode electrode 4 and includes boundary area 6. As Figure 2 indicates, the dI/dt withstanding capability is improved effectively by the $He^{2+}$ ion amount of dose of $1.0 \times 10^{10}$ cm$^{-2}$ or more and more effectively by the $He^{2+}$ ion amount of dose of $1.0 \times 10^{11}$ cm$^{-2}$ or more.

At the $He^{2+}$ ion amount of dose of $1.0 \times 10^{10}$ cm$^{-2}$, the carrier lifetime in first carrier lifetime region 10, in that the carrier lifetime is short, is 1.5 $\mu$s and the carrier diffusion length is 60 $\mu$m.

When the carrier lifetime (1.5 $\mu$s) in first carrier lifetime region 10 is 1/3 or less of the carrier lifetime (5.0 $\mu$s) in second carrier lifetime region 11, the dI/dt withstanding capability increases remarkably.

Figure 3 is a graph describing the relation between the amount of dose of $He^{2+}$ ion and the forward voltage of the p-i-n diode exhibiting a breakdown voltage of the 4500 V class. As Figure 3 indicates, the $He^{2+}$ ion irradiation does not almost affect the forward voltage, since the active region, in that the diode operation is conducted, occupies about 1% of the area, onto that $He^{2+}$ ions are irradiated.

Now, the relationships between the parameters of the p-i-n diode according to the first embodiment will be described with reference to Figures 4 through 6.

The results of the investigations conducted by changing the $He^{2+}$ ion irradiation location in the p-i-n diode exhibiting a breakdown voltage of the 4500 V class are described in Figures 4 through 6.

Figure 4 is a graph describing the relation between the width Lb of the first carrier lifetime region, which does not overlap with the anode electrode, and the dI/dt withstanding capability of the p-i-n diode exhibiting a breakdown voltage of the 4500 V class at the width La of 50 $\mu$m of the first carrier lifetime region, which overlaps with the anode electrode, the depth Da of 30 $\mu$m of the first carrier lifetime region from the surface of the semiconductor substrate on the side, thereon the p-type anode layer is formed, and the $He^{2+}$ ion amount of dose of $1.0 \times 10^{12}$ cm$^{-2}$.

The carrier diffusion length Lh in second carrier lifetime region 11, in that the carrier lifetime is long, is about 100 $\mu$m and the carrier diffusion length in first carrier lifetime region 10, in that the carrier lifetime is short, is 15 $\mu$m. The dI/dt withstanding capability of the p-i-n diode starts increasing drastically from around the width Lb, that is equal to the carrier diffusion length Lh in second carrier lifetime region 11.

In other words, a sufficiently high dI/dt withstanding capability is obtained when the width Lb and the carrier diffusion length Lh in second carrier lifetime region 11 are related by the following relational expres-

sion.

$$Lb > Lh$$

Figure 5 is a graph describing the relation between La and the dI/dt withstanding capability of the p-i-n diode exhibiting a breakdown voltage of the 4500 V class at Lb of 200 $\mu$m, Da of 30 $\mu$m and the He$^{2+}$ ion amount of dose of 1.0 x 10$^{12}$ cm$^{-2}$.

The carrier diffusion length in second carrier lifetime region 11 is about 100 $\mu$m and the carrier diffusion length Ls in first carrier lifetime region 10 is 15 $\mu$m. The dI/dt withstanding capability of the p-i-n diode starts increasing drastically from around the width La, that is equal to the carrier diffusion length Ls in first carrier lifetime region 10.

In other words, a sufficiently high dI/dt withstanding capability is obtained when the width La and the carrier diffusion length Ls in first carrier lifetime region 10 are related by the following relational expression.

$$La > Ls$$

Figure 6 is a graph describing the relation between the net depth (Da-Xj) of first carrier lifetime region 10 and the dI/dt withstanding capability of the p-i-n diode exhibiting a breakdown voltage of the 4500 V class at La of 100 $\mu$m, Lb of 100 $\mu$m and the He$^{2+}$ ion amount of dose of 1.0 x 10$^{12}$ cm$^{-2}$. Here, Xj is the depth of the pn-junction between p-type anode layer 2 and n-type semiconductor substrate 1. In the first embodiment, the junction depth Xj is 5 $\mu$m, that is the diffusion depth of p-type anode layer 2.

The carrier diffusion length in second carrier lifetime region 11 is about 100 $\mu$m and the carrier diffusion length in first carrier lifetime region is 15 $\mu$m. The dI/dt withstanding capability of the p-i-n diode starts increasing drastically from around the net depth (Da-Xj), that is equal to the carrier diffusion length in first carrier lifetime region 10.

In other words, a sufficiently high dI/dt withstanding capability is obtained when the net depth (Da-Xj) and the carrier diffusion length Ls in first carrier lifetime region 10 are related by the following relational expression.

$$Da-Xj > Ls$$

Now the second embodiment of the invention will be explained with reference to Figures 7 through 13. In Figures 7 through 13, the same reference numerals as used in Figures 1 through 6 are used to identify the same constituent elements.

Figure 7 is a cross sectional view of a p-i-n diode according to a second embodiment of the invention that includes a first carrier lifetime region 10, in that the carrier lifetime is short, in the other location of the semiconductor substrate different from the location of first carrier lifetime region 10 in Figure 1.

In the diode structure shown in Figure 7, the edge area of a p-type anode layer 2 and the edge area of an anode electrode 4 are spaced apart for 300 $\mu$m from each other.

First carrier lifetime region 10, in that the carrier lifetime is short, is formed in such a configuration that first carrier lifetime region 10 does not include the edge area X of p-type anode layer (p-type well region) 2, overlaps with an edge area of anode (drain) electrode 4, and includes a boundary area 6 (i.e. the contact area of p-type anode layer 2 and the lightly doped semiconductor layer). The lightly doped semiconductor layer corresponds to a second carrier lifetime region 11, in that the carrier lifetime is long. Hereinafter, the lightly doped semiconductor layer will be referred to as the "semiconductor layer 11".

By forming first carrier lifetime region 10 in the portion below the electrode edge area, current localization in the vicinity of the electrode edge area is prevented from occurring when a reverse bias voltage is applied, and the reverse-recovery withstanding capability (or the turn-off withstanding capability) is improved.

Now the investigations conducted on the p-i-n diode according to the second embodiment will be described with reference to Figures 8 and 9.

Figure 8 is the cross sectional view describing the practical structural parameters of the p-i-n diode according to the second embodiment. Figure 9 is a graph showing the simulated current density distribution in the vicinity of the pn-junction of the p-i-n diode shown in Fig, 8, to that He$^{2+}$ ion irradiation is applied.

In Figure 9, the edge area X of p-type anode layer 2 is located at the distance of 2000 $\mu$m. The contact area Y (i.e. the boundary area 6), at that anode electrode 4 contacts with p-type anode layer 2, is located at the distance of 1700 $\mu$m. In the second embodiment, first carrier lifetime region 10 does not include the edge area X of p-type anode layer 2, and overlaps with the electrode edge area. First carrier lifetime region 10 is formed only in the contact area Y, at that anode electrode 4 contacts with p-type anode layer 2.

As the current density distribution described in Figure 9 indicates, the current localization in the vicinity of the edge of the anode electrode is relaxed by shortening the carrier lifetime in the contact area Y, at that anode electrode 4 contacts with p-type anode layer 2.

Now comparative diode structures formed for the sake of comparison will be described with reference to Figures 10 through 13.

Figure 10 is a cross sectional view of a comparative diode structure. Figure 11 is a graph describing the current density distribution in the comparative diode structure of Figure 10. In Figure 11, the edge area X is positioned at the distance of 2000 $\mu$m and the contact area Y at the distance of 1700 $\mu$m in the same way as in Figure 9.

As described in Figure 11, the current density localizes not in the edge area X of p-type anode layer 2 but in the contact area Y, at that anode electrode 4 contacts with p-type anode layer 2. Therefore, the comparative diode structure is not effective to relax the current localization.

Figure 12 is a cross sectional view of another comparative diode structure, in that first carrier lifetime region 10, in that the carrier lifetime is short, is formed not below anode electrode 4 but in the edge area X of p-type anode layer 2. Figure 13 is a graph describing the current density distribution in the comparative diode structure of Figure 12.

In the diode structure shown in Figure 12, the current density localizes in the contact area Y in the same way as in the diode structure shown in Figure 10. Therefore, the diode structure shown in Figure 12 is not effective to relax the current localization.

The p-i-n diodes according to the other embodiments of the invention will be described below.

Now the invention will be described further with reference to Figure 14, that shows a cross sectional view of a p-i-n diode according to a third embodiment of the invention..

Referring now to Figure 14, the diode according to third embodiment includes a non-contact region 15 between p-type anode regions 2 and 2.

A first carrier lifetime region 10, in that the carrier lifetime is short, is formed in the same way as in the diode of Figure 1 in such a configuration that first carrier lifetime region 10 overlaps with the edge area X of anode electrode 4 and includes boundary area 6, at that p-type anode layer 2 and lightly doped semiconductor layer 11 contact with each other.

By forming first carrier lifetime region 10, in that the carrier lifetime is short, in such a configuration that first carrier lifetime region 10 overlaps with the edge area X of anode electrode 4 and includes the boundary area 6, current localization in the vicinity of the electrode edge area is prevented from occurring and the reverse-recovery withstanding capability (or the turn-off withstanding capability) is improved.

Since region 10, that is an irradiated region and in that the carrier life time is short, is a part of the operating (active) region, the rise of the forward voltage (on-voltage) is almost negligible.

Now the invention will be described further with reference to Figure 15, that shows a cross sectional view of a metal oxide-film semiconductor field effect transistor (MOSFET) according to a fourth embodiment of the invention.

In Figure 15, a p-type well region 20, an n-type source region 21, an n-type drain region 22, an oxide film 23, a source electrode 24 and a drain electrode 25 are shown.

A first carrier lifetime region 10, in that the carrier lifetime is short, overlaps with the edge area of source electrode 24 and includes a boundary area 6, at that p-type well region 20 contacts with lightly doped semiconductor layer 11.

By forming first carrier lifetime region 10, in that the carrier lifetime is short, in such a configuration that first carrier lifetime region 10 overlaps with the edge area of source electrode 24 and includes boundary area 6, current localization in the vicinity of the electrode edge area is prevented from occurring and the reverse-recovery withstanding capability (or the turn-off withstanding capability) is improved.

Since region 10, that is an irradiated region and in that the carrier life time is short, is a part of the operating (active) region, the rise of the forward voltage (on-voltage) is almost negligible.

Now the invention will be described further with reference to Figure 16, that shows a cross sectional view of a gate turnoff thyristor (GTO) according to a fifth embodiment of the invention.

In Figure 16, a p-type base region 30, an n-type cathode region 31, a p-type anode layer 32, a cathode electrode 33, an anode electrode 34 and a gate electrode 35 are shown.

A first carrier lifetime region 10, in that the carrier lifetime is short, overlaps with the edge area of cathode electrode 33 and includes a boundary area 6, at that a p-type base region 30 contacts with a lightly doped semiconductor layer 11.

By forming first carrier lifetime region 10, in that the carrier lifetime is short, in such a configuration that first carrier lifetime region 10 overlaps with the edge area of cathode electrode 33 and includes boundary area 6, current localization in the vicinity of the electrode edge area is prevented from occurring and the reverse-recovery withstanding capability (or the turn-off withstanding capability) is improved.

Since region 10, that is an irradiated region and in that the carrier life time is short, is a part of the operating (active) region, the rise of the forward voltage (on-voltage) is almost negligible.

Although the invention has been described so far in connection with the semiconductor structures including a means to adjust the carrier lifetime between the electrodes arranged on respective major surfaces of a semiconductor substrate facing opposite to each other, the invention is also applicable effectively to the semiconductor structures, which include the main electrodes formed on one major surface.

As explained above, current localization in the vicinity of the electrode edge area is prevented from occurring and the reverse-recovery withstanding capability (or the turn-off withstanding capability) is improved by forming regulation regions having different carrier lifetimes in such a configuration that one regulation region, in that the carrier lifetime is short, overlaps with the edge area of the electrode on the projection that projects the electrode vertically into a semiconductor substrate, and includes the boundary area in which the heavily doped region spreads into the lightly doped region of a first conductivity type.

## Claims

1. A semiconductor device comprising a semiconductor substrate (1), a heavily doped region (2) and an electrode (4), in which the semiconductor substrate (1) is a lightly doped layer of a first conductivity type, in which the heavily doped region (2) is of a second conductivity type and is formed selectively in the lightly doped layer, in which the electrode (4) is formed on a surface of the semiconductor substrate (1), in which the electrode (4) is in contact with said heavily doped region (2), in which the semiconductor substrate (1) comprises:

   a first carrier lifetime region (10); and
   a second carrier lifetime region (11);

   in which the carrier lifetime in the first carrier lifetime region (10) is shorter than the carrier lifetime in the second carrier lifetime region (11), **characterised in that** the heavily doped region (2) has a projection region which extends beyond the electrical contact area between the electrode (4) and the semiconductor substrate (1); **in that** the first carrier lifetime region (10) extends vertically into the semiconductor substrate (1), and partially overlaps with an edge area of the electrode (4) facing vertically into the semiconductor substrate (1), and **in that** the first carrier lifetime region (10) includes a boundary area (6) in which the heavily doped region (2) spreads into the lightly doped layer.

2. A semiconductor device according to Claim 1, wherein the first carrier lifetime region (10) extends over only an outermost edge area of the electrode (4) facing the semiconductor substrate (1), which outermost edge area is near to an edge area of the semiconductor device.

3. A semiconductor device according to Claim 1 or 2, wherein the first carrier lifetime region (10) extends perpendicular to a surface of the semiconductor substrate (1) on which the electrode (4) is formed.

4. A semiconductor device according to any of the preceding Claims, wherein the depth Da of the first carrier lifetime region (10) from the surface of the semiconductor substrate (1) on which the heavily doped region (2) is formed, the diffusion length Ls of the carriers in the first carrier lifetime region (10), and the depth Xj of the pn-junction between the heavily doped region (2) and the lightly doped layer, are related to each other by the following relational expression:

$$Da > Ls + Xj$$

5. A semiconductor device according to any of the preceding Claims, wherein the width La of a portion of the first carrier lifetime region (10) which overlaps with the electrode (4), and the diffusion length Ls of the carriers in the first carrier lifetime region (10), are related to each other by the following relational expression:

$$La > Ls$$

6. A semiconductor device according to any of the preceding Claims, wherein the width Lb of a portion of the first carrier lifetime region (10), which does not overlap with the electrode (4), and the diffusion length Lh of the carriers in the second carrier lifetime region (11), are related to each other by the following relational expression.

$$Lb > Lh$$

7. A semiconductor device according to any of the preceding Claims, wherein the carrier lifetime in the first carrier lifetime region (10) is 1/3 or less of the carrier lifetime in the second carrier lifetime region (11).

8. A semiconductor device according to any of the preceding Claims, wherein the semiconductor device is a diode, the heavily doped region (2) is an anode layer, and the electrode (4) is an anode electrode.

9. A method of manufacturing a semiconductor device comprising a semiconductor substrate (1), a heavily doped region (2) and an electrode (4), in which the semiconductor substrate (1) is a lightly doped layer of a first conductivity type, in which the heavily doped region (2) is of a second conductivity type and is formed selectively in the lightly doped layer, in which the electrode (4) is formed on a surface of the semiconductor substrate (1), in which the electrode (4) is in contact with said heavily doped region (2), in which the semiconductor substrate (1) comprises a first carrier lifetime region (10) and a second carried lifetime region (11), in which the carrier lifetime in the first carrier lifetime region (10) is shorter than the carrier lifetime in the second carrier lifetime region (11), **characterised in that** the heavily doped region (2) has a projection region which extends beyond the electrical contact area between the electrode (4) and the semiconductor substrate (1); **in that** the first carrier lifetime region (10) extends vertically into the semiconductor substrate (1), and partially overlaps with an edge area of the electrode (4) facing vertically into the semiconductor substrate (1), and **in that** the first carrier lifetime region (10) includes a boundary area (6) in which the heavily doped region (2) spreads into the lightly doped layer, in which the method comprises irradiating a particle beam to form the first carrier lifetime region (10).

10. The method according to Claim 9, wherein the particle beam is irradiated from a surface of the semiconductor substrate (1) on which the electrode (4) is formed.

11. The method according to Claim 9 or 10, wherein the particle beam comprises $He^{2+}$ ions or protons.

12. The method according to Claim 11, wherein $He^{2+}$ ions are irradiated at the amount of dose of $1 \times 10^{10}$ $cm^{-2}$ or more.

13. The method according to any of Claims 9 to 12, wherein the carrier lifetime in the first carrier lifetime region (10) is 1/3 or less of the carrier lifetime in the second carrier lifetime region (11).

14. The method according to any of Claims 9 to 13, wherein the semiconductor device is a diode, the heavily doped region (2) is an anode layer, and the electrode (4) is an anode electrode.

**Patentansprüche**

1. Ein Halbleiterbauelement umfassend ein Halbleitersubstrat (1), ein stark dotiertes Gebiet (2) und eine Elektrode (4), wobei das Halbleitersubstrat (1) eine schwach dotierte Schicht eines ersten Leitfähigkeitstyps ist, wobei das stark dotierte Gebiet (2) von einem zweiten Leitfähigkeitstyp ist und selektiv in der schwach dotierten Schicht gebildet ist, wobei die Elektrode (4) auf einer Oberfläche des Halbleitersubstrats (1) gebildet ist, wobei die Elektrode (4) in Kontakt mit besagtem stark dotiertem Gebiet (2) ist, und wobei das Halbleitersubstrat (1) ein Gebiet (10) mit einer ersten Ladungsträgerlebensdauer und ein Gebiet (11) mit einer zweiten Ladungsträgerlebensdauer umfasst, wobei die Ladungsträgerlebensdauer in dem Gebiet (10) der ersten Ladungsträgerlebensdauer kürzer ist als die Ladungsträgerlebensdauer in dem Gebiet (11) der zweiten Ladungsträgerlebensdauer, **dadurch gekennzeichnet, dass** das stark dotierte Gebiet (2) ein Vorsprungsgebiet hat, welches sich über das Gebiet des elektrischen Kontakts zwischen der Elektrode (4) und dem Halbleitersubstrat (1) hinaus erstreckt, dass das Gebiet (10) der ersten Ladungsträgerlebensdauer sich vertikal in das Halbleitersubstrat (1) hinein erstreckt und teilweise einen Kantenbereich der Elektrode (4), welcher vertikal auf das Halbleitersubstrat (1) trifft, überlappt, und dass das Gebiet (10) der ersten Ladungsträgerlebensdauer ein Grenzgebiet (6) einschließt, in dem sich das stark dotierte Gebiet (2) in die schwach dotierte Schicht hinein ausbreitet.

2. Ein Halbleiterbauelement nach Anspruch 1, wobei das Gebiet (10) der ersten Ladungsträgerlebensdauer sich nur über einen äußersten Kantenbereich der Elektrode (4), der auf das Halbleitersubstrat (1) trifft, erstreckt, wobei der äußerste Kantenbereich nahe bei einem Kantenbereich des Halbleiterbauelements ist.

3. Ein Halbleiterbauelement nach Anspruch 1 oder 2, wobei sich das Gebiet (10) der ersten Ladungsträgerlebensdauer senkrecht zu einer Oberfläche des Halbleitersubstrats (1), auf dem die Elektrode (4) gebildet ist, erstreckt.

4. Ein Halbleiterbauelement nach einem der vorausgehenden Ansprüche, wobei die Tiefe Da des Gebiets (10) der ersten Ladungsträgerlebensdauer von der Oberfläche des Halbleitersubstrats (1) aus, auf der das stark dotierte Gebiet (2) gebildet ist, die Diffusionslänge Ls der Ladungsträger in dem Gebiet (10) der ersten Ladungsträgerlebensdauer und die Tiefe Xj des pn-Übergangs zwischen dem stark dotierten Gebiet (2) und der schwach dotierten Schicht miteinander gemäß folgender Beziehung zusammenhängen:

$$Da > Ls + Xj$$

5. Ein Halbleiterbauelement nach einem der vorausgehenden Ansprüche, wobei die Breite La eines Abschnitts des Gebiets (10) der ersten Ladungsträgerlebensdauer, welcher die Elektrode (4) überlappt, und die Diffusionslänge Ls der Ladungsträger in dem Gebiet (10) der ersten Ladungsträgerlebensdauer miteinander gemäß folgender Beziehung zusammenhängen:

$$La > Ls$$

6. Ein Halbleiterbauelement nach einem der vorausge-

henden Ansprüche, wobei die Breite Lb eines Abschnitts des Gebiets (10) der ersten Ladungsträgerlebensdauer, welcher die Elektrode (4) nicht überlappt, und die Diffusionslänge Lh der Ladungsträger in dem Gebiet (11) der zweiten Ladungsträgerlebensdauer miteinander gemäß der folgenden Beziehung zusammenhängen:

$$Lb > Lh$$

**7.** Ein Halbleiterbauelement nach einem der vorausgehenden Ansprüche, wobei die Ladungsträgerlebensdauer in dem Gebiet (10) der ersten Ladungsträgerlebensdauer 1/3 oder weniger der Ladungsträgerlebensdauer in dem Gebiet (11) der zweiten Ladungsträgerlebensdauer ist.

**8.** Ein Halbleiterbauelement nach einem der vorausgehenden Ansprüche, wobei das Halbleiterbauelement eine Diode ist, das stark dotierte Gebiet (2) eine Anodenschicht ist, und die Elektrode (4) eine Anodenelektrode ist.

**9.** Ein Verfahren zur Herstellung eines Halbleiterbauelements, welches ein Halbleitersubstrat (1), ein stark dotiertes Gebiet (2) und eine Elektrode (4) umfasst, wobei das Halbleitersubstrat (1) eine schwach dotierte Schicht eines ersten Leitfähigkeitstyps ist, wobei das stark dotierte Gebiet (2) von einem zweiten Leitfähigkeitstyp ist und selektiv in der schwach dotierten Schicht gebildet ist, wobei die Elektrode (4) auf einer Oberfläche des Halbleitersubstrats (1) gebildet ist, wobei die Elektrode (4) in Kontakt mit besagtem stark dotiertem Gebiet (2) ist, wobei das Halbleitersubstrat (1) ein Gebiet (10) mit einer ersten Ladungsträgerlebensdauer und ein Gebiet (11) mit einer zweiten Ladungsträgerlebensdauer umfasst, wobei die Ladungsträgerlebensdauer in dem Gebiet (10) der ersten Ladungsträgerlebensdauer kürzer ist als die Ladungsträgerlebensdauer in dem Gebiet (11) der zweiten Ladungsträgerlebensdauer, **dadurch gekennzeichnet, dass** das stark dotierte Gebiet (2) ein Vorsprungsgebiet hat, welches sich über das Gebiet des elektrischen Kontakts zwischen der Elektrode (4) und dem Halbleitersubstrat (1) hinaus erstreckt, dass das Gebiet (10) der ersten Ladungsträgerlebensdauer sich vertikal in das Halbleitersubstrat (1) hinein erstreckt und teilweise einen Kantenbereich der Elektrode (4), welcher vertikal auf das Halbleitersubstrat (1) trifft, überlappt, und dass das Gebiet (10) der ersten Ladungsträgerlebensdauer ein Grenzgebiet (6) einschließt, in dem sich das stark dotierte Gebiet (2) in die schwach dotierte Schicht hinein ausbreitet, wobei das Verfahren die Bestrahlung mit einem Teilchenstrahl umfasst, um das Gebiet (10) der ersten Ladungsträgerlebensdauer zu bilden.

**10.** Das Verfahren nach Anspruch 9, wobei der Teilchenstrahl von einer Oberfläche des Halbleitersubstrats (1) aus eingestrahlt wird, auf dem die Elektrode (4) gebildet wird.

**11.** Das Verfahren nach Anspruch 9 oder 10, wobei der Teilchenstrahl $He^{2+}$-Ionen oder Protonen enthält.

**12.** Das Verfahren nach Anspruch 11, wobei $He^{2+}$-Ionen mit einer Dosis von $1 \times 10^{10}$ $cm^{-2}$ oder mehr eingestrahlt werden.

**13.** Das Verfahren nach einem der Ansprüche 9 bis 12, wobei die Ladungsträgerlebensdauer in dem Gebiet (10) der ersten Ladungsträgerlebensdauer 1/3 oder weniger der Ladungsträgerlebensdauer in dem Gebiet (11) der zweiten Ladungsträgerlebensdauer ist.

**14.** Das Verfahren nach einem der Ansprüche 9 bis 13, wobei das Halbleiterbauelement eine Diode ist, das stark dotierte Gebiet (2) eine Anodenschicht ist, und die Elektrode (4) eine Anodenelektrode ist.

## Revendications

**1.** Dispositif semi-conducteur comprenant un substrat semi-conducteur (1), une région fortement dopée (2) et une électrode (4), dans lequel le substrat semi-conducteur (1) est une couche faiblement dopée d'un premier type de conductivité, dans lequel la région fortement dopée (2) est d'un second type de conductivité et est formée de manière sélective sur la couche faiblement dopée, dans lequel l'électrode (4) est formée sur une surface du substrat semi-conducteur (1), dans lequel l'électrode (4) est au contact de ladite région fortement dopée (2), dans lequel le substrat semi-conducteur (1) comprend :

une région (10) à première durée de vie de porteurs de charges ; et
une région (11) à seconde durée de vie de porteurs de charges ;
la durée de vie des porteurs de charges dans la région (10) à première durée de vie de porteurs de charges étant plus courte que la durée de vie des porteurs de charges dans la région (11) à seconde durée de vie de porteurs de charges, **caractérisé en ce que** la région fortement dopée (2) comporte une zone saillante qui s'étend au-delà de la surface de contact électrique entre l'électrode (4) et le substrat semi-conducteur (1) ; **en ce que** la région (10) à première durée de vie de porteurs de charges s'étend vertica-

lement jusque dans le substrat semi-conducteur (1) et chevauche partiellement une zone de bord de l'électrode (4) orientée verticalement vers le substrat semi-conducteur (1), et **en ce que** la région (10) à première durée de vie de porteurs de charges comporte une zone limite (6) dans laquelle la région fortement dopée (2) s'étale jusque dans la couche faiblement dopée.

2. Dispositif semi-conducteur selon la revendication 1, dans lequel la région (10) à première durée de vie de porteurs de charges s'étend seulement sur une zone de bord extérieur de l'électrode (4) en regard du substrat semi-conducteur (1), laquelle zone de bord extérieur est proche d'une zone de bord du dispositif semi-conducteur.

3. Dispositif semi-conducteur selon la revendication 1 ou 2, dans lequel la région (10) à première durée de vie de porteurs de charges s'étend perpendiculairement à une surface du substrat semi-conducteur (1) sur laquelle est formée l'électrode (4).

4. Dispositif semi-conducteur selon l'une quelconque des revendications précédentes, dans lequel la profondeur Da de la région (10) à première durée de vie de porteurs de charges depuis la surface du substrat semi-conducteur (1) sur laquelle est formée la région fortement dopée (2), la longueur de diffusion Ls des porteurs dans la région (10) à première durée de vie de porteurs de charges et la profondeur Xj de la jonction pn entre la région fortement dopée (2) et la couche faiblement dopée sont liées les unes aux autres par la relation suivante :

$$Da > Ls + Xj$$

5. Dispositif semi-conducteur selon l'une quelconque des revendications précédentes, dans lequel la largeur La d'une partie de la région (10) à première durée de vie de porteurs de charges qui chevauche l'électrode (4), et la longueur de diffusion Ls des porteurs dans la région (10) à première durée de vie de porteurs de charges sont liées l'une à l'autre par la relation suivante :

$$La > Ls$$

6. Dispositif semi-conducteur selon l'une quelconque des revendications précédentes, dans lequel la largeur Lb d'une partie de la région (10) à première durée de vie de porteurs de charges, qui ne chevauche pas l'électrode (4), et la longueur de diffusion Lh des porteurs dans la région (11) à seconde durée de vie de porteurs de charges sont liées l'une à l'autre par la relation suivante :

$$Lb > Lh$$

7. Dispositif semi-conducteur selon l'une quelconque des revendications précédentes, dans lequel la durée de vie des porteurs de charges dans la région (10) à première durée de vie de porteurs de charges est égale à 1/3 ou moins par rapport à la durée de vie des porteurs de charges dans la région (11) à seconde durée de vie de porteurs de charges.

8. Dispositif semi-conducteur selon l'une quelconque des revendications précédentes, dans lequel le dispositif semi-conducteur est une diode, la région fortement dopée (2) est une couche d'anode et l'électrode (4) est une électrode d'anode.

9. Procédé de fabrication d'un dispositif semi-conducteur comprenant un substrat semi-conducteur (1), une région fortement dopée (2) et une électrode (4), dans lequel le substrat semi-conducteur (1) est une couche faiblement dopée d'un premier type de conductivité, dans lequel la région fortement dopée (2) est d'un second type de conductivité et est formée de manière sélective dans la couche faiblement dopée, dans lequel l'électrode (4) est formée sur une surface du substrat semi-conducteur (1), dans lequel l'électrode (4) est au contact de ladite région fortement dopée (2), dans lequel le substrat semi-conducteur (1) comporte une région (10) à première durée de vie de porteurs de charges et une région (11) à seconde durée de vie de porteurs de charges, dans lequel la durée de vie des porteurs de charges dans la région (10) à première durée de vie de porteurs de charges est plus courte que la durée de vie des porteurs de charges dans la région (11) à seconde durée de vie de porteurs de charges, **caractérisé en ce que** la région fortement dopée (2) comporte une partie saillante qui s'étend au-delà de la surface de contact électrique entre l'électrode (4) et le substrat semi-conducteur (1) ; **en ce que** la région (10) à première durée de vie de porteurs de charges s'étend verticalement jusque dans le substrat semi-conducteur (1) et chevauche partiellement une zone de bord de l'électrode (4) orientée verticalement vers le substrat semi-conducteur (1), et **en ce que** la région (10) à première durée de vie de porteurs de charges comporte une zone limite (6) dans laquelle la région fortement dopée (2) s'étale jusque dans la couche faiblement dopée, le procédé comprenant une irradiation d'un faisceau de particules pour former la région (10) à première durée de vie de porteurs de charges.

10. Procédé selon la revendication 9, dans lequel le faisceau de particules est irradié depuis une surface du substrat semi-conducteur (1) sur laquelle est formée l'électrode (4).

**11.** Procédé selon la revendication 9 ou 10, dans lequel le faisceau de particules contient des ions $He^{2+}$ ou des protons.

**12.** Procédé selon la revendication 11, dans lequel des ions $He^{2+}$ sont irradiés à raison d'une dose de 1 x $10^{10}$ cm$^{-2}$ ou plus.

**13.** Procédé selon l'une quelconque des revendications 9 à 12, dans lequel la durée de vie des porteurs de charges dans la région (10) à première durée de vie de porteurs de charges est égale à 1/3 ou moins de la durée de vie des porteurs de charges dans la région (11) à seconde durée de vie de porteurs de charges.

**14.** Procédé selon l'une quelconque des revendications 9 à 13, dans lequel le dispositif semi-conducteur est une diode, la région fortement dopée (2) est une couche d'anode et l'électrode (4) est une électrode d'anode.

**Figure 1**

**Figure 2**

Relation between He$^{2+}$ ion amount of dose and
dI/dt withstanding capability

**Figure 3**

Relation between He$^{2+}$ ion amount of
dose and forward voltage

**Figure 4**

Relation between the width Lb and
dI/dt withstanding capability

**Figure 5**

Relation between the width La and dI/dt
withstanding capability

**Figure 6**

Relation between the depth (Da-Xj) and
dI/dt withstanding capability

Figure 7

Figure 8

**Figure 9**

Current density distribution

**Figure 10**

## Figure 11

Current density distribution

## Figure 12

**Figure 13**

Distance ($\mu$m)
Current density distribution

**Figure 14**

Figure 15

(MOS FET)

Figure 16

(GTO)

**Figure 17**